(19) Europäisches Patentamt
European Patent Office
Office européen des brevets

(11) **EP 3 159 300 B1**

(12) **FASCICULE DE BREVET EUROPEEN**

(45) Date de publication et mention
de la délivrance du brevet:
**12.02.2020 Bulletin 2020/07**

(51) Int Cl.:
***B81B 3/00*** *(2006.01)*

(21) Numéro de dépôt: **16194875.7**

(22) Date de dépôt: **20.10.2016**

(54) **STRUCTURE MICROELECTROMECANIQUE ET/OU NANOELECTROMECANIQUE A ACTIONNEMENT ELECTROTHERMIQUE COMPORTANT AU MOINS DEUX POUTRES D'ACTIONNEMENT POLARISABLES DIFFEREMMENT**

MIKROELEKTROMECHANISCHE UND/ODER NANOELEKTROMECHANISCHE STRUKTUR MIT MINDESTENS ZWEI UNTERSCHIEDLICH POLARISIERTEN THERMISCHEN AKTUATOREN

ELECTROTHERMAL ACTIVATED MEMS AND/OR NEMS STRUCTURE HAVING AT LEAST TWO DIFFERENTLY POLARISED THERMAL ACTUATORS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.10.2015 FR 1560045**

(43) Date de publication de la demande:
**26.04.2017 Bulletin 2017/17**

(73) Titulaires:
• **COMMISSARIAT À L'ÉNERGIE ATOMIQUE ET AUX ÉNERGIES ALTERNATIVES**
**75015 Paris (FR)**
• **SAFRAN ELECTRONICS & DEFENSE**
**92100 Boulogne Billancourt (FR)**

(72) Inventeurs:
• **JOURDAN, Guillaume**
**38000 Grenoble (FR)**
• **LEHEE, Guillaume**
**92100 Boulogne Billancourt (FR)**

(74) Mandataire: **Brevalex**
**95, rue d'Amsterdam**
**75378 Paris Cedex 8 (FR)**

(56) Documents cités:
EP-A1- 2 711 696        EP-A2- 2 322 971
US-A1- 2015 047 078     US-B1- 6 675 578

**Description**

## DOMAINE TECHNIQUE ET ÉTAT DE LA TECHNIQUE ANTÉRIEURE

La présente invention se rapporte à une structure microélectromécanique et/ou nanoélectromécanique à actionnement électrothermique comportant au moins deux poutres d'actionnement polarisables différemment, par exemple pour réaliser un actionneur ou un capteur.

Les systèmes microélectromécaniques (MEMS pour Microelectromechanical systems en terminologie anglo-saxonne) et/ou nanoélectromécaniques (NEMS pour Nanoelectromechanical systems en terminologie anglo-saxonne) comportent une partie fixe et au moins une partie mobile et des moyens d'actionnement pour mettre en mouvement la partie mobile par rapport à la partie fixe

Le dispositif d'actionnement peut être de différents types.

Le dispositif d'actionnement peut être de type électrostatique, comportant des électrodes d'actionnement, par exemple sous forme de peignes capacitifs ou d'électrodes en regard, qui occupent un espace important et qui peuvent être de tailles comparables à celle du MEMS ou du NEMS. En outre, l'intensité de la force capacitive décroît fortement lorsque les dimensions du MEMS ou du NEMS se réduisent. De plus l'actionnement électrostatique nécessite des espaces inter électrodes inférieures à quelques $\mu$m afin de pouvoir générer des forces suffisamment importantes. Ces espaces inter électrodes constituent souvent l'une des principales sources de dissipation d'énergie dans les MEMS et NEMS qui est due au phénomène d'amortissement appelé squeeze film damping en terminologie anglo-saxonne, même sous vide (jusqu'à 0,001 - 0,1 mbar).

Le dispositif d'actionnement peut être de type piézoélectrique, utilisant un empilement de matériaux piézoélectriques. D'une part le dispositif est relativement encombrant vis-à-vis de la structure MEMS ou NEMS à actionner. D'autre part, le procédé de réalisation de l'empilement de matériaux piézoélectriques peut être complexe.

Le dispositif d'actionnement peut être de type magnétique comportant un aimant permanent. Il peut présenter également des problèmes d'encombrement. De plus l'efficacité de ce dispositif diminue fortement avec la taille du MEMS ou du NEMS.

Il existe également un dispositif d'actionnement de type électrothermique. L'actionnement électrothermique utilise les propriétés thermoélastiques des solides pour mettre en mouvement des structures MEMS. En effet, lorsqu'un conducteur électrique est polarisé électriquement, celui-ci dissipe de l'énergie par effet Joule, ce qui engendre un échauffement du conducteur qui se dilate en raison des propriétés thermoélastiques du matériau qui constitue la structure du MEMS ou du NEMS.

Le document Rahafrooz A, Pourkamali S. Thermal-Piezoresistive Energy Pumps in Micromechanical Resonant Structures. IEEE Trans Electron Devices. 2012 Dec ; 59(12):3587-93 décrit une structure résonante comportant deux éléments suspendus reliés par deux poutres d'actionnement parallèles, les deux poutres d'actionnement étant chacune suspendues au substrat au moyen d'une poutre latérale encastrée. La polarisation des deux poutres d'actionnement via les deux poutres encastrées permet un échauffement des poutres d'actionnement et la génération d'un actionnement électrothermique. Les poutres se dilatent, les deux éléments suspendus sont alors mis en mouvement l'un par rapport à l'autre. En appliquant une polarisation sinusoïdale, les éléments suspendus sont mis en vibration. Un résonateur haute fréquence peut être réalisé. Le courant de polarisation circule dans une poutre latérale, dans les deux poutres d'actionnement et dans l'autre poutre latérale. Les deux poutres d'actionnement sont donc activées par le même courant, connaissent le même échauffement qui génère les mêmes forces électrothermiques en phase.

Le *document* Xiabobo Guo, Yun-bo Yi, Rahafrooz A, Pourkamali, Gas Sensing using thermally actuated dual plate resonators and self-sustained oscillators. Frequency Control Symposium (FCS), 2012 IEEE International. 2012. p. 1-5 décrit un système sensible au gaz environnant comportant deux éléments suspendus reliés par deux poutres d'actionnement parallèles. Chaque élément suspendu est raccordé au substrat par deux poutres sollicitées en flexion.

Une structure comportant deux poutres d'actionnement disposées de part et d'autre de la partie mobile à déplacer ne peut être réalisée. En effet, le courant de polarisation circulerait dans une poutre d'actionnement, dans la partie mobile et dans l'autre poutre d'actionnement. Les forces électrothermiques ainsi générées s'opposeraient. Des contraintes fortes s'appliquent donc à la forme des structures à actionnement électrothermique de l'état de la technique. US 6 675 578 B1 divulgue une structure selon le préambule de la revendication 1.

## EXPOSÉ DE L'INVENTION

C'est par conséquent un but de la présente invention d'offrir une structure MEMS et/ou NEMS à actionnement électrothermique comportant au moins deux poutres d'actionnement permettant une grande liberté dans la disposition des poutres d'actionnement, notamment permettant d'avoir des poutres d'actionnement disposées de part et d'autre de la partie mobile sans que les forces électrothermiques générées dans les poutres s'opposent.

Le but précédemment énoncé est atteint par une structure MEMS et/ou NEMS à actionnement électrothermique comportant une partie fixe, au moins une partie mobile relativement à la partie fixe, au moins deux poutres d'actionnement connectées à la partie mobile et à la partie fixe et au moins un élément de liaison électrique entre la partie mobile et la partie fixe, et des moyens permettant de polariser différemment chaque poutre d'actionnement, et ainsi de générer des efforts différents. L'élément de liaison entre la partie mobile et la partie fixe permet que les poutres d'actionnement soient traversées par deux courants différents, chaque courant circulant de la partie fixe à travers une poutre d'actionnement et ensuite à travers l'élément de liaison.

En d'autres termes, on prévoit un troisième conducteur électrique en plus des deux poutres d'actionnement permettant de réaliser deux circuits électriques pouvant être polarisés séparément, chaque circuit électrique comprenant une poutre d'actionnement.

Grâce à l'invention, on peut réaliser des structures dans lesquelles les deux poutres d'actionnement sont situées de part et d'autre de la partie mobile et dont les forces d'actionnement générées sont constructives.

Les poutres d'actionnement peuvent être disposées de telle sorte qu'elles déplacent la partie mobile en translation et/ou en rotation.

De manière très avantageuse, les poutres d'actionnement sont polarisées de telle sorte que les flux thermiques provenant des poutres d'actionnement vers la partie mobile se compensent.

De manière très avantageuse, les poutres d'actionnement ont au moins une dimension transversale inférieure ou égale à 500 nm, à de telles dimensions l'échauffement des poutres est plus important en raison d'une augmentation de la résistivité thermique du matériau par rapport à la valeur du matériau en volume. Les forces d'actionnement générées par cet auto-échauffement sont ainsi amplifiées.

L'élément de liaison peut avantageusement présenter une configuration et/ou une disposition par rapport à la poutre d'actionnement, telles que la force générée par effet électrothermique dans l'élément de liaison ne s'oppose pas et/ou ne détériore pas l'action des poutres d'actionnement.

De manière très avantageuse, les épaisseurs des poutres d'actionnement sont choisies inférieures à celle de la partie mobile et à celle de l'élément de liaison, de préférence inférieures ou égales à la moitié de l'épaisseur de la partie mobile et de l'épaisseur de l'élément de liaison. Une telle structure offre un bon rendement énergétique. En effet, il résulte de cette différence d'épaisseur entre les poutres d'actionnement et celles de la partie mobile et de l'élément de liaison que la résistance électrique des poutres est très grande par rapport à celle de la partie mobile et à celle de l'élément de liaison, et que la densité de courant est concentrée dans les poutres d'actionnement. Les pertes par effet Joule sont ainsi concentrées dans les poutres et l'élévation de température est favorisée dans les poutres d'actionnement. Le courant délivré pour l'actionnement peut être réduit, ce qui rend la structure MEMS et/ou NEMS compatibles avec des systèmes portables et/ou grand public.

La présente invention a alors pour objet une structure microélectromécanique et/ou nanoélectromécanique à actionnement électrothermique telle que définie dans la revendication 1.

De préférence, les poutres d'actionnement électrothermique comportent un ou plusieurs matériaux thermoélastiques aptes à se déformer sous l'effet d'un échauffement thermique induit par effet Joule par le courant électrique destiné à circuler dans lesdites poutres. Le ou les matériaux est ou sont choisis parmi le silicium, le SiC, le SiN par exemple.

Dans un exemple de réalisation, la première et la deuxième poutre d'actionnement sont alignées et disposées de part et d'autre de la partie mobile.

L'élément de liaison présente avantageusement une forme telle qu'une force électrothermique générée en son sein ne s'oppose pas ou peu à la force électrothermique générée dans les poutres d'actionnement. Par exemple, l'élément de liaison a la forme d'un ressort en créneaux. En variante, l'élément de liaison pourrait être par exemple en forme de ressort en doubles spirales, chevrons etc.

Dans un exemple de réalisation, la structure comporte deux éléments de liaison alignés le long d'un axe perpendiculaire à un axe auquel les première et deuxième poutres d'actionnement sont parallèles.

La première et / ou la deuxième poutre d'actionnement est ou sont sous forme de nanofil. Les très faibles dimensions du nanofil permettent d'améliorer la résistivité thermique du matériau dans lequel le nanofil est fait et donc permettent d'augmenter l'échauffement thermique du matériau du nanofil pour une puissance électrique donnée. L'épaisseur et/ou la largeur des nanofils est ou sont inférieure(s) ou égale(s) à 500 nm.

Dans un exemple avantageux, la structure comporte au moins un premier ensemble de plusieurs premières poutres d'actionnement électrothermique aptes à appliquer simultanément une force électrothermique de même sens sur la partie mobile et/ou un deuxième ensemble de plusieurs deuxièmes poutres d'actionnement électrothermique, le premier ensemble et/ou le deuxième ensemble étant connectés respectivement à la première et à la deuxième source de polarisation. Lorsque les poutres d'actionnement sont des nanofils, la conductivité thermique des nanofils est diminuée et l'auto-échauffement est amélioré.

Dans un autre exemple de réalisation, la structure comporte une articulation en rotation entre la partie fixe et la partie mobile et dans laquelle les première et deuxième poutres d'actionnement sont disposées par rapport à la partie mobile de sorte à provoquer sa rotation par rapport à la partie fixe, ladite rotation étant dans le plan de la structure ou hors-plan.

Par exemple, l'articulation en rotation comporte les deux éléments de liaison alignés définissant l'axe de rotation, lesdits éléments de liaison étant déformables en torsion et les première et deuxième poutres d'actionnement sont reliées mécaniquement à la partie mobile de sorte que les forces électrothermiques générées dans les poutres d'actionnement provoquent la rotation hors-plan de la partie mobile. Dans un autre exemple, l'articulation en rotation comporte deux éléments de liaison dont les axes sont sécants.

Dans un autre exemple de réalisation, la partie mobile est reliée mécaniquement à la partie fixe par un ancrage, ledit ancrage formant un élément de liaison et dans laquelle les première et deuxième poutres d'actionnement sont orientées par rapport à la partie mobile pour provoquer sa déformation élastique.

De manière avantageuse, l'articulation en rotation est telle qu'elle permet également un déplacement en translation et les première et deuxième poutres d'actionnement sont reliées à un même côté de la partie mobile de part et d'autre de l'articulation.

La structure peut comporter deux premières poutres d'actionnement et deux deuxièmes poutres d'actionnement

Les poutres d'actionnement présentent de préférence des épaisseurs inférieures ou égales à la moitié d'une épaisseur de la partie mobile et inférieure ou égale à la moitié d'une épaisseur de l'élément de liaison.

De préférence également, les poutres d'actionnement présentent des rapports de forme compris entre 1 et 2.

La structure peut comporter des moyens de détection d'un déplacement de la partie mobile. Les moyens de détection peuvent être des moyens piézorésistifs. En variante, les moyens de détection pourraient être aussi par exemple piézoélectriques.

Avantageusement, les moyens de détection sont formés par au moins une des poutres d'actionnement.

La présente invention a également pour objet un système comportant au moins une structure selon l'invention, une première source de polarisation et une deuxième source de polarisation.

Dans un exemple, les première et deuxième sources de polarisation sont de type continu et ont des amplitudes différentes. Dans un autre exemple, première et deuxième sources de polarisation sont de type alternatif et sont en quadrature.

La présente invention a également pour objet un actionneur comportant au moins un système selon l'invention.

La présente invention a également pour objet un capteur comportant au moins un système selon l'invention.

La présente invention a également pour objet un procédé de commande d'un système selon l'invention, dans lequel les première et deuxième poutres d'actionnement sont polarisées avec des amplitudes différentes ou dans lequel les première et deuxième poutres d'actionnement sont polarisées en quadrature.

Le procédé de commande peut également comporter les étapes :

- échauffement de la partie mobile à une température donnée,

- modulation d'une amplitude et/ou d'une phase des polarisations des première et deuxième sources de polarisation de sorte que le flux thermique sur la première poutre d'actionnement tend à augmenter la température donnée et le flux thermique de la deuxième poutre d'actionnement tend à diminuer la température donnée et de sorte que la température de la partie mobile soit sensiblement constante.

## BRÈVE DESCRIPTION DES DESSINS

La présente invention sera mieux comprise sur la base de la description qui va suivre et des dessins en annexe sur lesquels:

- la figure 1 est une vue de dessus d'un exemple de réalisation d'une structure MEMS et/ou NEMS selon l'invention comportant deux poutres d'actionnement activées chacune par une source de courant différente,
- les figures 2A et 2B sont des vues en coupe selon les plans I-I et II-II respectivement de la structure de la figure 1,
- la figure 3 est une vue de dessus d'une variante très avantageuse de la structure de la figure 1, mettant en œuvre des nanofils,
- la figure 4 est une vue de dessus d'un autre exemple de réalisation d'une structure MEMS et/ou NEMS,
- la figure 5 est une vue de dessus d'un autre exemple de réalisation d'une structure MEMS et/ou NEMS,
- la figure 6 est une vue de dessus de deux structures MEMS et/ou NEMS selon un autre exemple de réalisation dans lequel la partie mobile est déformée en flexion,
- la figure 7A est une vue de dessus d'un exemple de réalisation d'une structure MEMS et/ou NEMS selon l'invention à mouvement de rotation hors-plan,
- la figure 7B est une vue en coupe longitudinale de la structure de la figure 7A le long d'un plan III-III en cours d'actionnement,
- la figure 8 est une vue de dessus d'un exemple de réalisation d'une structure MEMS et/ou NEMS, l'élément mobile pouvant être déplacé en rotation et/ou en translation,
la figure 9 est une vue de dessus d'un exemple de réalisation d'une structure MEMS et/ou NEMS à quatre poutres d'actionnement,
- la figure 10 est une vue de dessus d'un exemple de réalisation d'une structure MEMS et/ou NEMS à deux poutres d'actionnement activées chacune par une source de courant différente, particulièrement adaptée à une compensation du flux thermique,
- la figure 11 est une représentation du schéma thermique de la structure de la figure 10,
- la figure 12 est une vue de dessus d'une variante de la structure de la figure 10 comportant des moyens de détection de déplacement de la partie mobile,
- la figure 13 est une représentation schématique d'une structure MEMS et/ou NEMS comportant des moyens de modification de l'intensité de la force appliquée à la partie mobile par une poutre d'actionnement électrothermique,
- la figure 14 est une variante de la structure de la figure 13.

Les représentations des structures ne sont pas à l'échelle, les proportions entre les différents éléments des structures n'étant pas nécessairement respectées.

## EXPOSÉ DÉTAILLÉ DE MODES DE RÉALISATION PARTICULIERS

La description qui va suivre va décrire des structures MEMS et/ou NEMS à actionnement électrothermique, ces structures pouvant être mises en œuvre dans un grand nombre d'applications, telles que les actionneurs pour déplacer un miroir ou un interrupteur et les capteurs.

Dans la présente demande, on entend par « partie mobile » une partie d'une structure MEMS et/ou NEMS apte à se déplacer au moins partiellement par rapport à une partie fixe de la structure MEMS et/ou NEMS dans le plan de la structure ou hors-plan de la structure. On entend par déplacement « au moins partiellement », une partie qui serait par exemple ancrée par une extrémité sur la partie fixe et dont une autre extrémité serait déformée mécaniquement et de manière élastique.

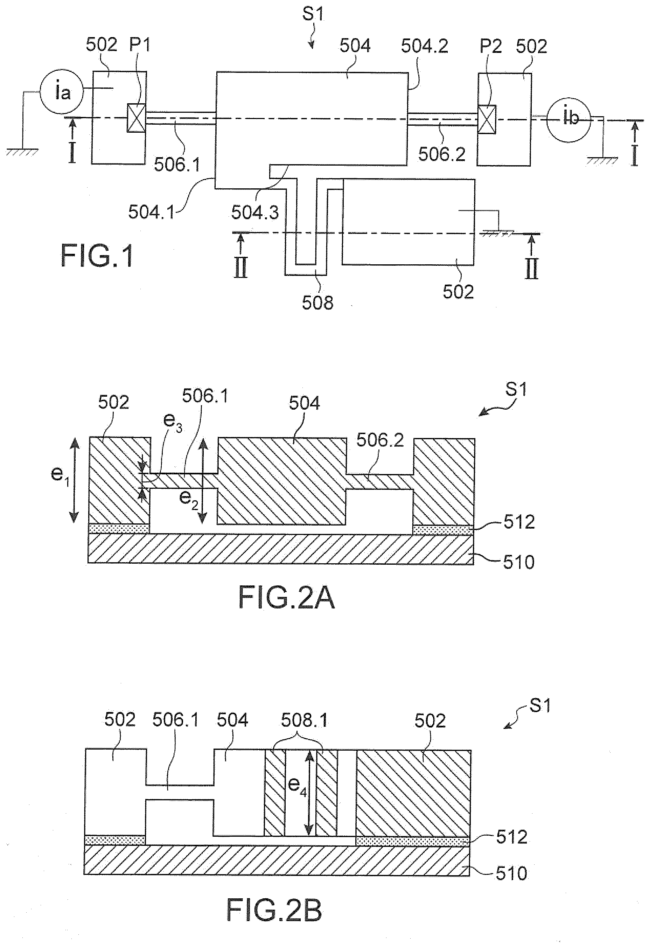

Sur les figures 1, 2A et 2B, on peut voir un exemple de réalisation d'une structure S1.

La structure S1 comporte une partie fixe 502, une partie mobile 504, une première poutre d'actionnement 506.1 s'étendant entre la partie fixe et un bord 504.1 de la partie mobile 504, deux poutres d'actionnement 506.1, 506.2 s'étendant entre la partie fixe et la partie mobile. La poutre 506.1 s'étend entre la partie fixe et un bord 504.1 de la partie mobile 504 et la poutre 506.2 s'étend entre la partie fixe et un bord 504.2 de la partie mobile 504 opposé au bord 504.1, et au moins un élément de liaison 508 entre la partie mobile 504 et la partie fixe 502. L'élément de liaison 508 dans l'exemple représenté s'étend en un bord 504.3 de la partie mobile perpendiculaire aux bords 504.1 et 504.2. Il a en outre avantageusement la forme d'un ressort en forme de créneaux. Il présente une certaine souplesse dans la direction de l'axe X. En outre cette forme permet avantageusement de réduire la force électrothermique apparaissant dans l'élément de liaison et qui sera décrite ci-dessous.

Dans l'exemple représenté, les deux poutres d'actionnement sont alignées le long de la direction X de déplacement dans le plan de la partie mobile.

Dans l'exemple représenté sur la figure 2A, la poutre d'actionnement 506 est située sensiblement dans le plan médian de la partie mobile 504. Cette disposition n'est pas limitative. En variante, les poutres d'actionnement 506.1, 506.2 pourraient être situées en dessous du plan médian dans la partie mobile 504. Selon une autre variante, les poutres d'actionnement 506.1, 506.2 pourraient être situées au-dessus du plan médian, leurs faces supérieures étant dans le plan de la face supérieure de la partie mobile 504.

Comme on peut le voir sur les figures 2A et 2B, la partie fixe 502 est solidaire d'un substrat 510 qui s'étend sous toute la structure MEMS et/ou NEMS et est isolé électriquement de celui-ci par une couche isolante électrique 512. L'épaisseur de la partie fixe 502 qui est conductrice électrique est égale à e2. La partie mobile présente une épaisseur e1. Dans cet exemple et de manière préférée, du fait du procédé de réalisation la partie fixe 502 et la partie mobile 504 sont issues de la même couche en matériau conducteur électrique, par exemple en un matériau semi-conducteur. Il en résulte que e1 = e2.

L'épaisseur de la poutre d'actionnement est désignée e3 et l'épaisseur de l'élément de liaison est désignée e4.

Dans l'exemple représenté, les poutres d'actionnement ont avantageusement une épaisseur inférieure à l'épaisseur de la partie mobile et de l'épaisseur de l'élément de liaison, et très avantageusement inférieure à la moitié de l'épaisseur de la partie mobile et à la moitié de l'épaisseur de l'élément de liaison, i.e. e3 ≤ e2/2 et e3 ≤ e4/2. Les avantages résultant de ce choix d'épaisseur sera décrit ci-dessous.

La partie fixe 502, la partie mobile 504, les poutres d'actionnement 506 et l'élément de liaison 508 sont réalisés dans un ou des matériaux conducteurs électriques.

Le ou les éléments de liaison peuvent également former des moyens de suspension. Ils peuvent avantageusement présenter une raideur importante hors-plan limitant les déplacements hors-plans de la partie mobile.

De préférence, la largeur de la poutre d'actionnement est choisie de sorte à avoir un rapport de forme compris entre 1 et 2.

De préférence, les poutres d'actionnement ont une longueur supérieure ou égale à au moins 10 fois leur dimension transverse la plus importante. Le rapport entre la longueur et la dimension transverse la plus grande est avantageusement compris entre 5 et 200. Il est à noter que plus la longueur de la poutre d'actionnement est importante plus la gamme de fonctionnement de la poutre d'actionnement diminue du fait du phénomène de flambage.

Dans le dimensionnement des poutres d'actionnement la limite de flambage est prise en compte. La limite de flambage décroit en $L^2$ : Par exemple, pour une poutre de 12 $\mu$m de long, la contrainte maximale autorisée en compression est de 300 MPa pour une section de 250 nm x 250 nm. Dans ce cas précis, le rapport L/t atteint 48. Les contraintes recherchées pour réaliser de l'actionnement peuvent atteindre plusieurs 100 aines de MPa pour les valeurs les plus fortes.

Des poutres d'actionnement longues offrent de meilleures performances.

En effet, des poutres d'actionnement longues présentent une plus grande résistance électrique. Le rendement global de la puissance Joule peut alors être amélioré et les courants nécessaires peuvent être plus faibles, ce qui permet de réduire la puissance fournie par la source de courant pour de mêmes performances.

Des poutres d'actionnement longue(s) offrent une plus grande isolation thermique ce qui permet d'augmenter l'effet d'auto-échauffement lors du passage d'un courant électrique à puissance électrique constante, ou de diminuer la consommation électrique à force électrothermique constante.

La poutre a par exemple une section de 250 nm × 250 nm et la longueur de la poutre d'actionnement est par exemple comprise entre 100 nm et 100 $\mu$m.

e3 est par exemple compris entre 10 nm et 100 $\mu$m et elet e2 sont par exemple compris entre 20 nm et 100 $\mu$m.

Les poutres d'actionnement peuvent être réalisées avec des matériaux adaptés à la réalisation de structure MEMS et/ou NEMS. La force d'actionnement générée par une poutre dépend du produit du coefficient de dilatation $\alpha$ et du module d'Young E. Ce produit est de préférence maximisé.

Par exemple, pour du silicium : a=2,6 ppm/K et E=169 GPa, pour du nitrure de silicium : a=3.26 ppm/K et E=1125 GPa et pour du carbure de silicium : a=4 ppm/K et E=450 GPa. Le carbure de silicium est particulièrement avantageux.

La structure MEMS et/ou NEMS est destinée à être reliée à deux sources de polarisation en courant ou en tension désignée par exemple par des plots de contact P1, P2 réalisés sur la partie fixe de part et d'autre de la partie mobile. Cette source S peut être alternative ou continue.

Dans la suite de la description et à des fins de simplicité, nous considérons uniquement une source de courant électrique qui sera désignée « source de courant ».

Chaque poutre d'actionnement 506.1, 506.2 est destinée à être traversée par un courant la, Ib respectivement. Par exemple deux sources de courant distinctes sont reliées chacune à un plot de contact P1, P2 respectivement situés sur la partie fixe 502 à proximité de poutres d'actionnement 506.1, 506.2. Les plots de contact P1 et P2 ne sont connectés électriquement l'un à l'autre que par le MEMS et les poutres d'actionnement. Cette alimentation de chaque poutre d'actionnement 506.1, 506.2 par un courant différent est rendue possible par la présence de l'élément de liaison qui forme un chemin de conduction distinct des poutres d'actionnement, et permet aux courants la et Ib de circuler par l'élément de liaison vers la partie fixe. L'élément de liaison est donc traversé par le courant la + Ib.

Chaque courant la, Ib peut être contrôlé séparément et permettre la génération de forces électrothermiques différentes dans chaque poutre d'actionnement. Par exemple, les courants la et Ib peuvent être des signaux en créneaux en opposition de phase ou des courants sinusoïdaux par exemple également en opposition de phase. Il est alors possible d'avoir une interférence constructive des forces électrothermiques appliquées par les deux poutres d'actionnement alignées.

Les courants la, Ib circulant dans les poutres d'actionnement 506.1, 506.2 provoquent l'auto-échauffement de chacune des poutres et la génération d'une force électrothermique dans chacune des poutres. Puisque les courants peuvent être commandés séparément ils peuvent être commandés de sorte que les forces électrothermiques générées soient constructives.

L'élément de liaison 508 est traversé par les courants la et Ib, il assure la fermeture du circuit électrique. L'élément de liaison 508 subit également un auto-échauffement mais du fait de sa configuration en ressort, les différentes branches perpendiculaires à l'axe X peuvent se dilater librement et la force exercée par l'élément de liaison 508 sur la partie mobile 504 est négligeable par rapport à celle exercée par les poutres d'actionnement. Par ailleurs, en choisissant un élément de liaison dont la raideur est faible dans la direction X par rapport à la raideur de la structure MEMS et/ou NEMS, la déformation thermoélastique a principalement lieu sur l'élément de liaison 508. Une force d'actionnement très faible s'exerce alors sur la partie mobile 504.

Grâce à la structure de la figure 1, la partie mobile peut être déplacée vers la droite ou vers la gauche à partir de sa position d'équilibre en activant l'une ou l'autre des poutres d'actionnement par effet électrothermique. Le courant d'activation I1 ou I2 circulant dans l'élément de liaison 508 et non dans l'autre poutre d'actionnement, il n'y a pas génération d'une force dans l'autre poutre d'actionnement qui s'opposerait au déplacement de la partie mobile. Dans les structures à actionnement électrothermique de l'état de la technique de tels déplacements dans un sens ou dans le sens opposé sur commande à partir d'une position d'équilibre ne sont pas envisageables.

De manière avantageuse, en choisissant l'épaisseur des poutres d'actionnement très inférieure à celles de la partie mobile et de l'élément de liaison, la résistance de la poutre est supérieure à celle de la partie mobile qui permet l'accès du courant aux poutres d'actionnement.

Il y a une concentration de la densité de courant dans les poutres d'actionnement, ce qui favorise une élévation de température plus importante dans celle-ci en comparaison des parties fixe et mobile. La puissance fournie sert principalement à échauffer les poutres et donc à générer une force par effet électrothermique. Cette force est d'autant plus grande que l'échauffement est grand. On obtient alors un meilleur rendement énergétique.

Si le courant est un courant alternatif, la partie mobile est mise en vibration. La fréquence de vibration peut être d'autant plus élevée que la constante de temps thermique des poutres d'actionnement est faible, ceci est notamment le cas lorsqu'elle présente de faibles dimensions. La longueur de la poutre est par exemple comprise entre 100 nm et 20 μm.

L'épaisseur de la partie fixe n'est pas prise en compte, car celle-ci présente une très grande surface par rapport à celle de la partie mobile et de l'élément de liaison, par conséquent sa résistance est typiquement très inférieure à celles de la partie mobile et de l'élément de liaison. En outre, des contraintes de dimensionnement imposées par le cahier des charges du MEMS s'appliquent à la partie mobile. Pour l'élément de liaison, il n'est pas ou difficilement envisageable qu'il présente une grande largeur, sinon il pourrait perturber le fonctionnement mécanique de la structure.

A titre d'exemple, considérons une structure MEMS et/ou NEMS dans laquelle la poutre d'actionnement a une épaisseur de 0,25 μm, une largeur de 0,25 μm et une longueur 5 μm et dans laquelle l'élément de liaison a une épaisseur de 1 μm, une largeur de 2 μm et une longueur de 50 μm. Considérons en outre que la résistance d'accès est principalement celle de l'élément de liaison. De plus les poutres d'actionnement et l'élément de liaison sont réalisés dans le même matériau.

Le rendement r pour chaque poutre d'actionnement s'écrit :

$$r = \frac{Ppoutres}{P \ tolale} = \frac{Rpoutre}{R \ poutre + accés} = 96\%$$

La mise en œuvre de poutres d'actionnement présentant une épaisseur faible, permet avantageusement d'atteindre des résistances de poutres de plusieurs milliers d'Ohm. De telles résistances permettent d'atteindre des courants d'actionnement dans la gamme 100 μA - 1mA avec l'aide d'un générateur de l'ordre de 1V. Le courant délivré par le générateur est proche ou dans la gamme de courant visé. Dans ces conditions, la majeure partie de la puissance délivrée par un générateur de 1V est transmise aux poutres d'actionnement sans avoir recours à des convertisseurs DC-DC.

Par exemple, pour des poutres d'actionnement ayant les dimensions 0,25 μm x 0,25 μm x 5 μm, la résistance électrique R de la poutre d'actionnement est de :

R = 4100 Ω avec un dopage $2 \times 10^{19}$ cm$^{-3}$.

R = 1860 Ω avec un dopage $5 \times 10^{19}$ cm$^{-3}$.

Avantageusement, l'élément de liaison 508 présentant une épaisseur très supérieure à celle des poutres d'actionnement, il présente également une résistance électrique faible, son auto-échauffement est réduit par rapport à la poutre. La force électrothermique résultante peut par exemple être au moins d'un ordre de grandeur plus bas que celle générée dans la poutre d'actionnement. De préférence, la résistance électrique du ou des éléments de liaison est au moins cinq fois plus faible que celle des poutres d'actionnement.

En variante, le matériau de l'élément de liaison pourrait être dopé pour présenter une meilleure conductivité électrique et thermique que celle du matériau des poutres d'actionnement ou être réalisé dans un matériau présentant un coefficient de dilatation plus faible que celui du matériau de la poutre d'actionnement.

On peut prévoir, par exemple dans une application à un capteur, des moyens de détection des mouvements de la partie mobile générés par la force électrothermique. Les poutres d'actionnement peuvent être réalisées en matériau piézorésistif formant les moyens de détection. La variation de résistance électrique des poutres permet de connaître le mouvement de la partie mobile. Il sera compris que l'on peut remplacer chaque poutre d'actionnement par plusieurs poutres d'actionnement disposées en parallèle d'un point de vue électrique et qui seraient activées par la même source de courant. En variante, les moyens de détection peuvent être de type piézoélectrique.

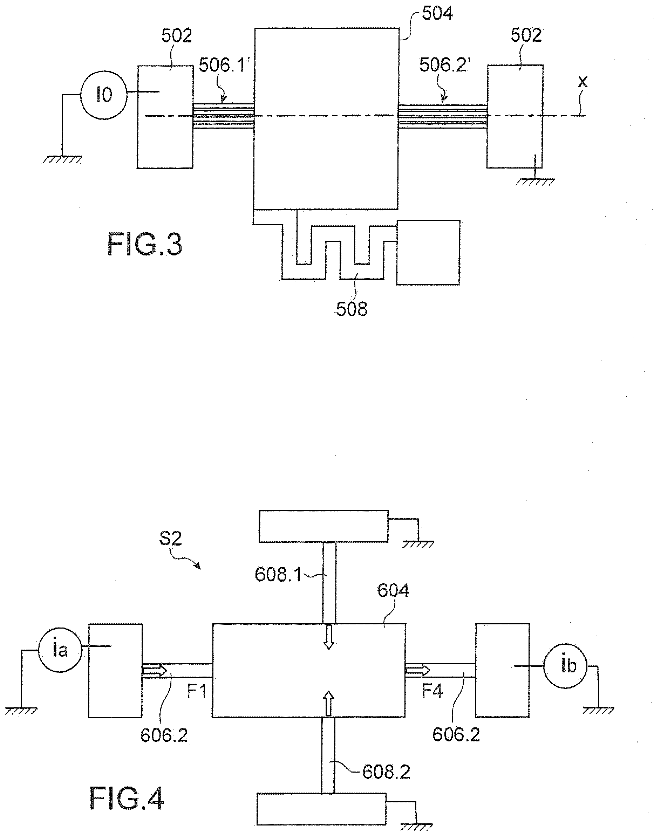

De manière particulièrement avantageuse, les poutres d'actionnement peuvent avoir des dimensions transversales telles qu'elles forment des nanofils. Sur la figure 3, on peut voir un exemple d'une telle structure.

Plusieurs nanofils 506.1' parallèles entre eux remplacent la poutre 506.1 et plusieurs nanofils 506.2' parallèles entre eux remplacent la poutre 506.2.

La largeur et/ou l'épaisseur d'un nanofil est ou sont inférieure à 500 nm. A de telles dimensions, le nanofil présente des conductivités thermiques inférieures à celles du matériau en volume en raison de l'intensification de processus d'interaction de type phonon-phonon ou phonon-surface. Par exemple, dans le cas du silicium, une réduction d'un facteur 3 peut être observée pour des nanofils de section 250 nm x 250 nm, les nanofils présentent une conductivité thermique de 50 W/m/K alors que le silicium massif présente une conductivité thermique de 140 W/m/K.

Le profil de température T(x) au sein d'une poutre de longueur L traversée par un courant de densité j peut être approché par :

$$T = T_0 + \frac{\rho j^2}{2\kappa} x(L - x)$$

p est la résistivité, $\kappa$ la conductivité thermique. La température maximale est atteinte au milieu de la poutre :

$$\Delta T_{max} = \frac{\rho j^2}{8\kappa} L^2$$

L'amplitude d'auto-échauffement étant inversement proportionnelle à la conductivité thermique, un nanofil de section nanométrique, par exemple dont la largeur et/ou l'épaisseur est ou sont comprise(s) entre 10 nm et 500 nm, bénéficie ainsi d'un échauffement amplifié et donc d'une force d'actionnement amplifiée par unité de surface (section de la poutre), par rapport à une poutre d'actionnement de dimensions supérieures.

Des poutres d'actionnement sous la forme de micropoutres de quelques $\mu$m de dimensions transversales et de longueur par exemple entre 5 $\mu$m à 10 $\mu$m présentent l'avantage d'avoir une inertie thermique réduite par rapport à des poutres d'actionnement de microsystèmes de l'état de la technique, les temps de réponse dans la génération de la force sont alors plus courts lors d'une sollicitation électrique. De telles poutres d'actionnement permettent de réaliser des structures MEMS et/ou NEMS avec des fréquences de résonance élevées, par exemple dans la gamme de fréquence 1MHz et 1GHz.

La configuration dans laquelle plusieurs nanofils représentant au total la même section qu'une poutre d'actionnement unique est particulièrement avantageuse, car à section totale constante, la puissance électrique consommée est identique à celle consommée par une poutre d'actionnement unique, la raideur mécanique exercée sur les structures aux extrémités du nanofil est équivalente, mais du fait de l'amplification décrite ci-dessus, la force totale exercée par les nanofils est amplifiée par rapport à celle appliquée par une poutre d'actionnement unique.

Cette structure présente alors un rendement énergétique amélioré.

Si on considère n nanofils remplaçant une poutre, présentant la même section et la même longueur, on a pour le nanofil i: : $R_i = nR_p$ avec $R_p$ la résistance de la poutre.

La puissance dans un nanofil s'écrit alors

$$P_i = R_i \times \left(\frac{I}{n}\right)^2 = \frac{R_p I^2}{n}, \text{ soit la puissance totale}$$

dans les n nanofils $= \sum_i^N P_i = R_p I^2$, soit la puissance consommée par la poutre de section totale équivalente.

La raideur d'un nanofil $k_i = \frac{k_p}{n}$, avec $k_p$ la raideur de la poutre, soit une raideur longitudinale équivalente $k = k_p$ identique à la raideur de la poutre de section totale équivalente.

La constante de temps pour chaque nanofil s'écrit $\tau_i = R_{th,i} C_i = R_{th} C$ dans le cas où les paramètres matériaux sont inchangés.

Avec

$$R_{th} = \frac{L}{S\kappa}$$

$$C = cLS$$

$$R_{thi} = \frac{nL}{S\kappa_i}$$

$$C_i = \frac{cLS}{n}$$

c est la capacité thermique par unité de volume, C la capacité thermique de la poutre d'actionnement, $C_i$ la capacité thermique d'un nanofil, $\kappa$ la conductivité thermique de la poutre d'actionnement, $\kappa_i$ est la conductivité thermique du nanofil, S la section de la poutre d'actionnement et S/n la section d'un nanofil, L la longueur de la poutre d'actionnement et d'un nanofil. En pratique, la constante de temps ou temps de réponse augmente légèrement puisque la conductivité thermique diminue. On peut compenser au moins en partie cette augmentation en réduisant longueur du nanofil. Le temps de réponse d'un nanofil peut être supérieur à celui d'un nanofil plus épais du fait de la diminution de la conductivité thermique.

Les nanofils peuvent par exemple être réalisés par des techniques de gravure planaires qui permettent d'atteindre des largeurs de poutres de l'ordre de 100 nm en utilisant la méthode de gravure ultraviolet profond (Deep Ultra Violet en terminologie anglo-saxonne) ou de 5 nm en utilisant la méthode de gravure par rayon électronique (« e-beam lithography » en terminologie anglo-saxonne), tout en conservant des dimensions identiques pour le reste des structures MEMS/NEMS.

L'épaisseur des nanofils peut être obtenue en mettant en œuvre une couche structurelle plus mince que celle utilisée pour le reste de la structure MEMS. Un tel procédé de réalisation mettant en œuvre deux couches structurelles est bien connu de l'homme du métier.

La structure selon l'invention permet d'avoir des poutres d'actionnement de taille réduite en comparaison de la partie mobile qu'elle(s) met ou mettent en mouvement tout en conservant une bonne efficacité d'actionnement. Par exemple, le rapport entre les surfaces des structures planaires du MEMS (ces surfaces incluent celle de la partie mobile et des pistes fixes utilisées pour la polarisation) et de la poutre peut atteindre typiquement des facteurs 1000-10000. En termes de volume, le rapport peut être compris entre 10000 et 100000.

Sur la figure 4, on peut voir un autre exemple de structure S2.

La structure S2 comporte deux poutres d'actionnement 606.1, 606.2 alignées, disposées de part et d'autre de la partie mobile 604. Elle comporte deux éléments de liaisons 608.1 608.2 alignés et s'étendant suivant une direction perpendiculaire à la direction des poutres d'actionnement. Des courants Ia, Ib traversent les poutres d'actionnement 606.1, 606.2 respectivement et ensuite circulent vers la partie fixe par les éléments de liaison 608.1, 608.2. Les forces électrothermiques générées dans les éléments de liaison 608.1, 608.2 se compensent et ne perturbent pas le déplacement de la partie mobile.

Une structure comportant n poutres d'actionnement, n étant au moins égal à 2 et m éléments de liaison, m étant au moins égal à 1, et q sources de courants indépendantes, q étant compris entre 2 et n compris, circulant dans les n poutres d'actionnement, ne sort pas du cadre de la présente invention.

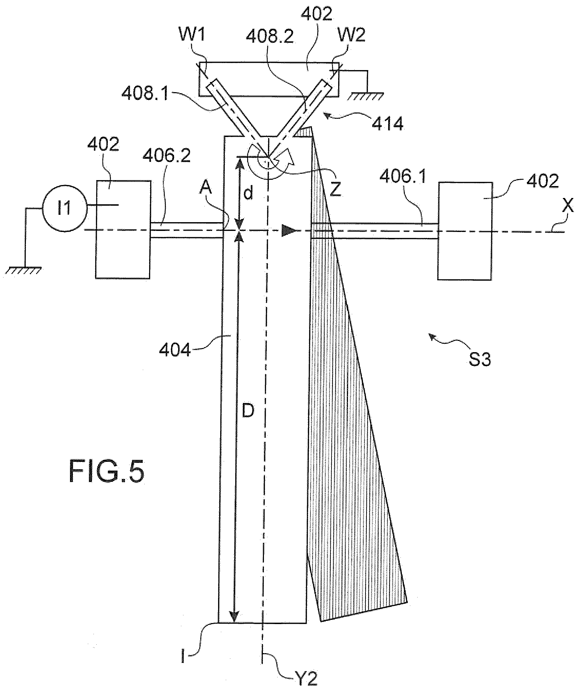

Sur la figure 5, on peut voir un autre exemple de structure S3 dans lequel la partie mobile est articulée en rotation dans le plan.

La structure S3 comporte une partie fixe 402, une partie mobile 404, des moyens d'articulation ou charnière 414 en rotation de la partie mobile 404 par rapport à la partie fixe, et deux poutres d'actionnement 406.1, 406.2 entre la partie fixe et la partie mobile.

La charnière comporte un axe de rotation Z perpendiculaire au plan de la structure et deux bras formant deux éléments de liaison 408.1, 408.2. Les deux éléments de liaison 408.1, 408.2 sont connectés à la partie fixe 402 et à la partie mobile 404 et sont inclinés l'un par rapport à l'autre de sorte que leurs axes WI, W2 soient sécants au niveau de la partie mobile 404, les axes W1 et W2 étant sécants en Z. A titre d'exemple non limitatif, l'angle entre les axes W1 et W2 peut par exemple être égal à 90°.

L'axe X des poutres d'actionnement et l'axe de rotation Z ne sont pas sécants, de sorte qu'une force électrothermique appliquée le long de l'axe X provoque une rotation de la partie mobile autour de l'axe Z. La partie mobile 404 se déplace dans le sens antihoraire sous l'effet de la force, la partie mobile prend alors la position représenté en pointillés et dans le sens horaire lorsque la force cesse.

Un auto-échauffement des poutres d'actionnement 406.1, 406.2 provoque donc une rotation de la partie mobile 404 autour de l'axe Z.

De préférence et comme cela est représenté sur la figure 5, la structure S3 permet d'amplifier l'amplitude de déplacement d'un point I situé sur la partie mobile à l'opposé de l'axe Z par rapport à l'axe X des poutres.

En effet, si on considère la distance d, entre le point d'intersection entre l'axe X et un axe Y2 formant l'axe longitudinal de la partie mobile 404 et le point d'intersection de Z et Y2, et la distance d entre et le point d'intersection de Z et Y2 et le point I, l'amplitude de déplacement du point I est amplifiée par rapport à celle du point d'intersection entre l'axe X et l'axe Y2 d'un rapport D/d.

Des rapports de l'ordre de 10 à 200 peuvent aisément être produits. Des amplitudes de l'ordre de la dizaine de nanomètres au niveau de la poutre d'actionnement peuvent provoquer des déplacements du point I sur plus d'1 μm.

Une telle structure peut par exemple être mise en œuvre pour mettre en mouvement les masses inertielles d'un gyromètre pour lequel les amplitudes de vibration peuvent atteindre plus d'1 μm.

Dans tous les exemples de réalisation, les poutres d'actionnement peuvent avoir des dimensions égales ou différentes, et dans les exemples comportant plusieurs éléments de liaison, ceux-ci peuvent avoir des dimensions égales ou différentes et des formes similaires ou différentes.

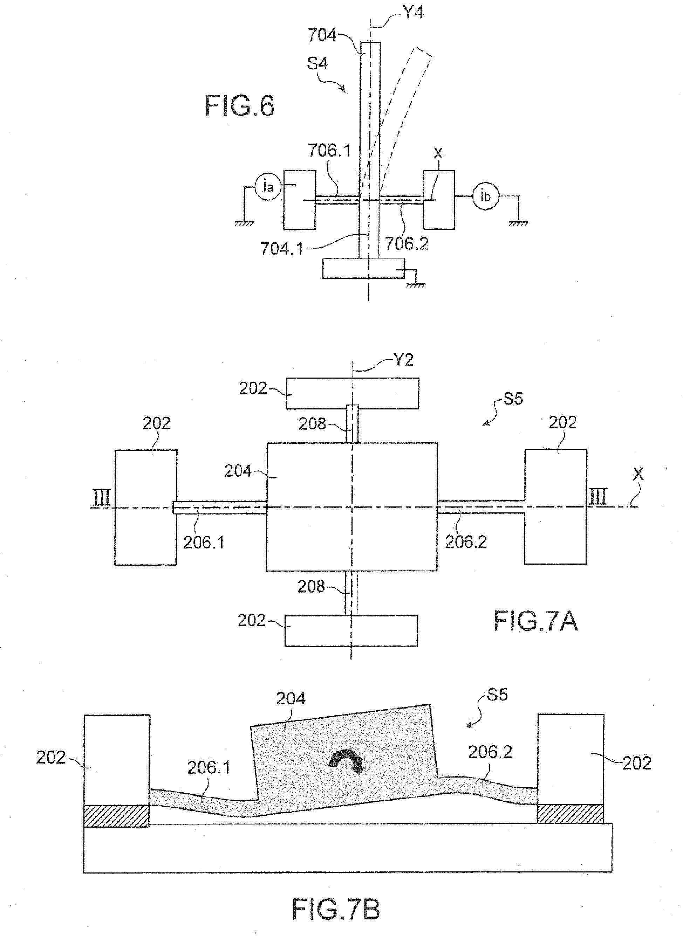

Sur la figure 6, on peut voir un autre exemple de réalisation d'une structure MEMS et/ou NEMS S4 dans laquelle la partie mobile est déformée mécaniquement par l'action de la poutre d'actionnement.

La figure S4 comporte une partie fixe 702, une partie mobile 704 et deux poutres d'actionnement 706.1 et 706.2, alignées dans l'exemple représenté et qui sont traversées par deux courants différents Ia, Ib. Dans l'exemple représenté, l'élément mobile s'étend selon une direction Y4 dans le plan et perpendiculaire à l'axe X. La partie mobile 704 est solidaire du substrat au niveau d'une extrémité longitudinale 704.1 par une liaison encastrement 716. La partie mobile est dimensionnée pour pouvoir se déformer en flexion sous l'effet de la force électrothermique appliquée par la poutre d'actionnement.

La liaison encastrement remplace l'élément de liaison, le courant d'actionnement circulant à travers la poutre et la liaison encastrement.

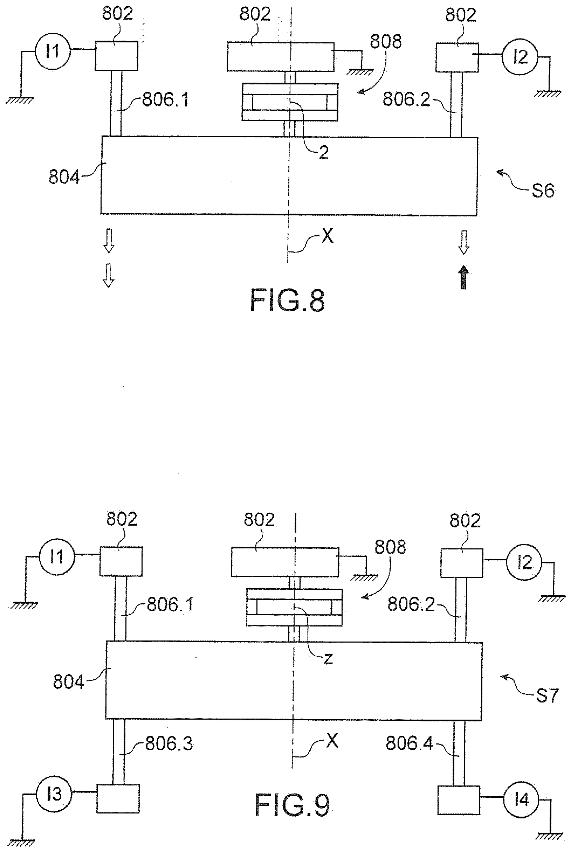

Lorsqu'un courant d'actionnement circule dans l'une ou les poutres d'actionnement 706.1, 706.2, l'une ou l'autre- s'auto-échauffent par effet Joule ce qui génère une force électrothermique qui s'applique sur la partie mobile 704. Du fait de la direction perpendiculaire des forces électrothermiques par rapport à l'axe de la partie mobile, celle-ci se déforme en flexion comme cela est représenté en pointillés sur la figure 9A.

Toute autre orientation des poutres d'actionnement par rapport à la partie mobile provoquant la déformation de la partie mobile selon un mode autre qu'un mode de flexion et/ou dans une direction hors-plan ne sort pas du cadre de la présente invention. Les poutres d'actionnement permettent d'actionner une structure déformable de dimensions égales ou légèrement supérieures à ses propres dimensions.

On peut prévoir que les poutres ne soient pas alignées provoquant alors plusieurs zones de déformation de la partie mobile en leur appliquant simultanément un courant indépendant.

Sur les figures 7A et 7B, on peut voir un exemple de réalisation d'un structure S5 dans lequel la partie mobile peut avoir un mouvement de rotation hors-plan.

La structure S5 comporte deux éléments de liaison 208 formés par des poutres et s'étendant perpendiculairement à l'axe des poutres d'actionnement 206.1, 206.2 de part et d'autre de la partie mobile 204. Les éléments de liaisons 208 sont alignés le long d'un axe Y2. En outre, les poutres d'actionnement 206.1, 208.2 comportent une face inférieure dans le même plan que la face de la partie mobile en regard du substrat. Par ailleurs, l'axe Y2 et les poutres d'actionnement 206.1, 206.2 sont dans des plans différents, par exemple les éléments de liaison 208 sont situés dans le plan médian de la partie mobile 204. L'axe de rotation se situe approximativement dans le plan médian contenant les éléments 208.

Les bras de liaison 208 sont réalisés de sorte à présenter une raideur suffisante à la flexion et être déformables en torsion afin de former un axe de rotation pour la partie mobile comme on peut le voir sur la figure 7B. En effet la force électrothermique qui apparaît au sein de l'une ou l'autre des poutres d'actionnement 206.1, 206.2, s'exerce sur la partie mobile 204 qui est fixée à la partie fixe 202 par les éléments de liaison 208, qui se déforment en torsion autour de l'axe Y2. La partie mobile 206 pivote alors autour de l'axe X dans le sens horaire ou le sens antihoraire suivant la poutre d'actionnement qui est auto-échauffée.

Les poutres d'actionnement peuvent être situées dans toute position par rapport à la partie mobile différente du plan contenant l'axe Y2 des bras de liaison 206.

Cette structure à actionnement hors-plan est particulièrement avantageuse car l'actionnement hors-plan est difficile à réaliser avec les structures de l'état de la technique, par exemple avec un actionnement de type capacitif. En effet dans un structure comportant des électrodes capacitives de type peignes inter-digités, le moment mécanique au niveau d'un axe de rotation située au niveau du plan médian de la structure MEMS est nul. Il faut alors ajouter des électrodes planaires localisées au-dessus ou en dessous du MEMS, ce qui complexifie la fabrication.

On peut envisager une structure comportant une poutre d'actionnement dans la partie supérieure de la structure et une poutre d'actionnement dans la partie inférieure, l'activation simultanée des deux poutres d'actionnement provoquant le basculement de la partie mobile. Les deux sources de polarisation polarisent les deux poutres de la même manière. On peut envisager de ne mettre en œuvre qu'une seule source de polarisation et de ne pas avoir d'élément de liaison conducteur électrique.

Sur la figure 8, on peut voir un autre exemple d'une structure MEMS et/ou NEMS S6.

La structure S6 comporte une partie fixe 802, une partie mobile 804, deux poutres d'actionnement 806.1, 806.2 parallèles et reliées à un même côté de la partie mobile et un élément de liaison 808 également relié au même côté de la partie mobile que les poutres d'actionnement. L'élément de liaison 808 présente une certaine élasticité permettant à la structure 804 de se déplacer dans le plan en translation selon X et permet le pivotement de de la masse autour de la direction Z.

Cette structure permet de contrôler finement les modes mécaniques que l'on souhaite exciter. Par exemple, l'amplitude et la phase dans le cas de signaux sinusoïdaux des courants traversant les poutres d'actionnement peuvent être adaptées afin de favoriser l'excitation d'un mode mécanique donné.

Par exemple, dans le cas de courants d'actionnement continus en phase dans les deux poutres d'actionnement 806.1, 806.2, la partie mobile 804 se déplace en translation le long de l'axe X. Dans le cas de courants d'actionnement continus en antiphase, la partie mobile est déplacée en rotation autour de l'axe Z.

On note $I_1$ le courant circulant dans la poutre 806.1 et I2 le courant circulant dans la poutre d'actionnement 806.2.

Dans le cas où des courants d'actionnement continus sont considérés, en écrivant $I_1 = i_a + i_b$ et $I_2 = i_a + \varepsilon \times i_b$, sachant que la force d'actionnement est proportionnelle au carré de l'intensité, les composantes de forces s'écrivent :

Pour la poutre 806.1 :

$$F_1 \propto i_a{}^2 + i_b{}^2 + 2i_a i_b$$

Pour la poutre 806.2 :

$$F_2 \propto i_a{}^2 + i_b{}^2 + 2i_a i_b \text{ si } \varepsilon = 1,$$

les deux forces sont alors en phase. Les deux poutres subissent le même auto-échauffement et des forces électrothermiques de même intensité sont générées, la partie mobile se déplace en translation. L'élément de liaison 808 se déforme selon la direction X.

$$F_2 \propto i_a{}^2 + i_b{}^2 - 2i_a i_b \text{ si } \varepsilon = -1,$$

les deux forces comportent alors un terme en antiphase. Les deux poutres ne subissent pas le même auto-échauffement et des forces électrothermiques d'intensités différentes sont générées, la partie mobile se déplace en rotation autour de l'axe Z. L'élément de liaison 808 se déforme selon autour de l'axe Z.

Dans le cas où des courants d'actionnement sinusoïdaux sont considérés, en écrivant $I_1 = i_a \sin \omega t$ et $I_2 = i_a \sin \omega t + \varphi$, on a

Pour la poutre 1 :

$$F_1 \propto i_a{}^2 \frac{1 - \cos 2\omega t}{2}$$

Pour la poutre 2 :

$$F_2 \propto i_a{}^2 \frac{1 - \cos 2\omega t + 2\varphi}{2}.$$

En choisissant $\varphi = \frac{\pi}{2}$ par exemple on obtient des forces $F_1$ et $F_2$ en opposition de phase pour la composante à $2\omega$ provoquant une rotation de la partie mobile.

Une composante en phase statique existe, il en résulte un décalage en position de la partie mobile par rapport à sa position d'équilibre.

En considérant la structure S1 de la figure 1, dans laquelle les deux poutres d'actionnement sont alignées de part et d'autre de la partie mobile, la résultante des forces en opposition de phase appliquée à la partie mobile peut s'écrire :

$$\sum F \propto \cos 2\omega t$$

La structure S1 permet de supprimer les composantes statiques.

Sur la figure 9, on peut voir un autre exemple de structure S7 à quatre poutres d'actionnement permettant également de supprimer les composantes statiques. La structure S7 comporte, par rapport à la structure S6, deux poutres d'actionnement supplémentaires, une poutre 806.3 alignée avec la poutre 806.1 et reliée au côté de la partie mobile 804 opposé à celui auquel est reliée la poutre 806.1 et une poutre 806.4 alignée avec la poutre 806.2 et reliée au côté de la partie mobile opposé à celui auquel est reliée la poutre 806.2.

Chaque poutre d'actionnement 806.1, 806.2, 806.3, 806.4 est alimentée par son propre courant d'actionnement I1, I2, I3, I4 respectivement. Chaque courant génère un auto-échauffement et des forces électrothermiques qui s'appliquent sur la partie mobile.

En appliquant, par exemple, des courants i1 et i3 sinusoïdaux quadrature et des courant i2 et i4 sinusoïdaux quadrature, il est possible de supprimer les composantes statiques, la partie mobile 804 pouvant alors être déplacée en translation le long de l'axe X.

Si en outre, les courants i1 et i2 sont quadrature et i3 et i4 sont quadrature, la partie mobile 804 peut être excitée en rotation autour de l'axe Z.

Il sera compris qu'en choisissant une phase adaptée entre les courants circulant dans les différentes poutres d'actionnement, il est possible d'optimiser l'excitation d'un mode souhaité pour toute structure, par exemple dans le cas de structures comportant plusieurs parties mobiles, avec chacune plusieurs degrés de liberté.

En outre, de manière très avantageuse, les structures selon l'invention peuvent permettre de compenser le flux thermique vu par la partie mobile et résultant de l'application du courant d'actionnement.

En effet dans une structure à actionnement électrothermique de l'état de la technique, l'application d'un signal sinusoïdal en tension ou en courant, un flux d'énergie thermique est appliqué à la structure ce qui provoque une modulation de température de la structure et en particulier de la partie mobile. Cette modulation peut avoir des effets sur la réponse mécanique de la structure en modifiant la raideur de l'élément de liaison.

Dans le cas à une application à un capteur de pression asservi, cette modulation de température peut chauffer le gaz dont la pression varie avec la température. Une telle modulation en température perturbe les mesures.

Une structure à au moins deux poutres d'actionnement alimentées par des courants différents peut permettre d'éviter, ou au moins de limiter, cette modulation en température de la structure.

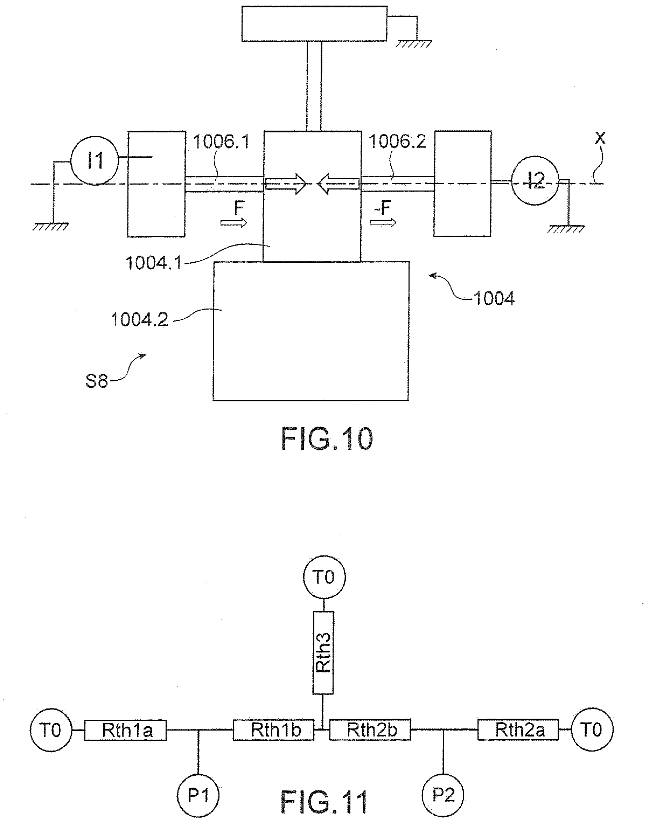

Sur la figure 10, on peut voir une structure S8 qui se rapproche de la structure S1. Dans la structure S8, l'élément de liaison est droit et non sous forme de ressort en créneau. Les poutres d'actionnement sont alignées le long de l'axe X de part et d'autre de la partie mobile 1004. De manière très avantageuse, les extrémités longitudinales des poutres d'actionnement 1006 qui sont ancrées sur la partie mobile 1004 sont situées à une courte distance l'une de l'autre. Dans l'exemple représenté, la partie mobile 1004 comporte une partie étroite 1004.1 dans le sens de la direction X entre les deux poutres d'actionnement 1006.1, 1006.2, et une partie plus large 1004.2 située en dehors de l'espace entre les poutres. La partie 1004.2 peut former la partie fonctionnelle de la partie mobile 1004 et la partie 1004.1 former la partie d'actionnement ou d'excitation. Les extrémités d'ancrage des poutres d'actionnement 1006.1, 1006.2 sur la partie mobile 1004 sont donc rapprochées. La distance séparant les ancrages est par exemple 5 fois inférieure à la dimension de la partie mobile dans la direction d'alignement des ancrages, elle est par exemple comprise entre 10 nm et 50 $\mu$m, par exemple égale à 10 $\mu$m.

On applique à la poutre d'actionnement 1006.1 un courant de sorte à provoquer un échauffement de la poutre $T_0 + \Delta T$ et on applique à la poutre d'actionnement 1006.2 un courant de sorte à provoquer un échauffement de la poutre $T_0 - \Delta T$.

Sur la figure 11, on peut voir le circuit thermique de la structure S8.

Rth1a est donnée par la résistance thermique de la poutre d'actionnement 1006.1, Rth2a est donnée par la résistance thermique de la poutre d'actionnement 1006.2, Rthlb et Rth2b sont des résistances thermiques qui comportent une contribution des poutres d'actionnement 1006.1 et 1006.2 et de la partie mobile 1004. Rth3 est la résistance thermique de l'élément de liaison.

Par effet Joule, les poutres d'actionnement produisent des flux thermiques P1 et P2 respectivement. Les flux au niveau de la partie mobile se compensent parfaitement si Rthla=Rth2a et Rthlb=Rth2b pour des niveaux puissance identiques.

On annule donc les composantes variables. La structure est alors échauffée à température constante.

Les courants peuvent être sous la forme :

$$I_1 = i_0 + i_m(t) \text{ pour la poutre 1006.1,}$$

$$I_2 = i_0 - i_m(t) \text{ pour la poutre 1006.2}$$

On a alors $\Delta T = 2i_0 i_m$ et $T_0 \propto i_0{}^2 + i_m{}^2 \sim i_0{}^2$ si $i_0 \gg i_m$. On peut en effet, pour un échauffement donné $\Delta T$, augmenter $i_0$ et prendre $i_m \propto \frac{1}{i_0}$ pour réduire la composante non compensée. Idéalement, les courants sont de la forme, en prenant $i_0 > i_m(t)$ :

$$I_1 = i_0 \sqrt{1 + \frac{i_m(t)}{i_0}} \text{ pour la poutre 1006.1}$$

$$I_2 = i_0 \sqrt{1 - \frac{i_m(t)}{i_0}} \text{ pour la poutre 1006.2}$$

En cas d'excitation harmonique, il est avantageux de prendre :

$I_1 = i_a \sin \omega t$ pour la poutre 1006.1,
$I_2 = i_a \cos \omega t$ pour la poutre 1006.2.

Qui produisent les échauffements :

Pour la poutre 1006.1 : $T_1 \propto \dfrac{1 + \cos 2\omega t}{2}$

Pour la poutre 1006.2 : $T_2 \propto \dfrac{1 - \cos 2\omega t}{2}$

On a alors $\Delta T \propto \cos 2\omega t$ et $T_0$ est une constante.

Le flux thermique injecté dans la structure ne conserve que sa composante statique, il est donc constant : en effet le flux est proportionnel à la somme $I_1(t)^2 + I_2(t)^2 = i_a{}^2$ qui est constant.

La structure et en particulier la partie mobile 1004 ne subissent pas de modulation en température. Elle est échauffée à une température donnée qui peut être prise en compte dans le dimensionnement de la structure ou l'actionnement de celle-ci et/ou dans le traitement des signaux qu'elle transmet pour compenser cette élévation constante de température. Dans le cas de structure NEMS dont les dimensions de la partie mobile peuvent être proches de celles des poutres d'actionnement, l'élévation de température produit par le flux thermique peut être très important car la résistance thermique de l'élément de liaison peut être du même ordre de grandeur que celle des poutres d'actionnement : la compensation de flux permet de réduire de manière efficace la composante modulée de température du NEMS et ainsi de maintenir constantes les propriétés physiques du NEMS. Par exemple on peut citer les couches fonctionnelles utilisées pour adsorber des éléments chimiques ou biologiques, par exemple mises en œuvre dans des capteurs de masse gravimétrique, ou des couches magnétiques, des boîtes quantiques intégrées dans un NEMS, etc.

En variante, on pourrait modifier l'amplitude de l'un et/ou l'autre des courants traversant les poutres d'actionnement pour supprimer ou au moins réduire la composante dynamique du flux thermique résultant s'appliquant à la structure.

Cette compensation de flux thermique peut être très avantageuse lorsque la structure comportent des moyens de détection du déplacement de la partie mobile par exemple dans le cas d'un capteur, et plus généralement lorsque la structure comporte des organes de transduction sensibles à la température.

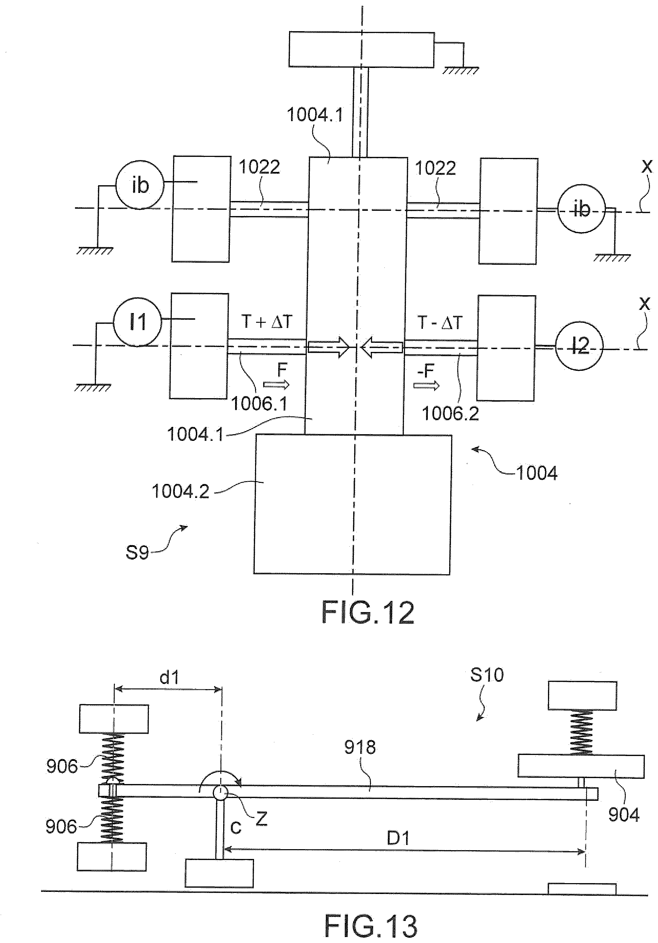

Sur la figure 12, on peut voir une structure S9 très proche de la structure S8, comportant en plus des moyens de transduction piézorésistifs 1022 ou jauges piézorésistives. Ces jauges sont sensibles aux variations de température. Dans l'exemple représenté, les jauges sont suspendues entre la partie fixe 1002 et la partie étroite 1004.1 de la partie mobile 1004 parallèlement aux poutres d'actionnement et de part et d'autre de la partie mobile, permettant par exemple une mesure différentielle.

Les courants I1 et I2 traversent les poutres d'actionnement 1006.1, 1006.2.

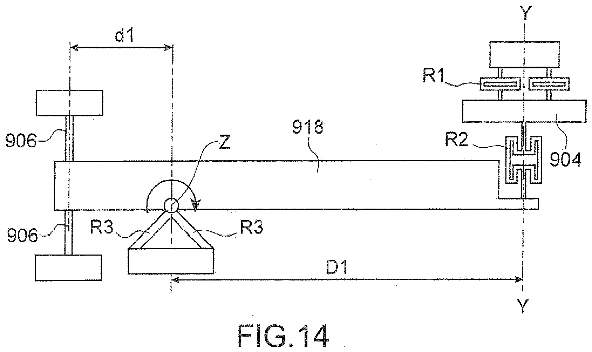

Lorsque les flux thermiques générés par les poutres d'actionnement 1006.1, 1006.2 sont compensés au niveau de la partie mobile comme cela a été décrit en relation avec les figures 13 et 14, il n'y a pas de modulation de température qui se transmette aux jauges par la partie mobile, la modulation de température synchrone avec le mouvement de la partie mobile est alors fortement réduite, ce qui a pour effet de réduire fortement le signal thermique, également appelé fond de mesure, au niveau des jauges piézorésistives. L'échauffement à une température constante des jauges est pris en compte le traitement des signaux qu'elles génèrent.

Le courant de polarisation ib des jauges peut être soit statique, soit modulée à une fréquence $\omega_b$ différente de la fréquence de vibration mécanique afin de ne pas générer de composante de fond qui se superpose au signal mécanique, puisqu'un effet joule apparaît également au sein des jauges. En revanche, une composante thermique peut être générée à $\omega_b$ et ses harmoniques sur la structuré. Le courant de polarisation des jauges peut toutefois être choisi suffisamment faible pour limiter les effets indésirables sur la structure.

De manière très avantageuse, les poutres d'actionnement peuvent être utilisées également pour mesurer les mouvements de la partie mobile en exploitant les propriétés de piézorésistivité du matériau de la poutre. Les fonctions d'actionnement et de détection peuvent ainsi être fournies par la même poutre. Ceci permet de réduire le nombre de plots de connexion extérieurs qui imposent des contraintes sévères sur les tailles du composant, en effet des plots de 50 x 50 μm peuvent être nécessaires pour assurer une connexion filaire. L'encombrement de la structure et encore réduit et sa réalisation est simplifiée.

Dans tous les exemples représentés, les plots peuvent être polarisés en tension ou en courant afin d'adapter les niveaux de courants qui traversent les poutres d'actionnement.

Dans tous les exemples de réalisation, les structures peuvent comporter plusieurs parties mobiles déplacées par plusieurs poutres d'actionnement activées par plusieurs sources de courant ou de tension. Par ailleurs, les poutres d'actionnement pourraient être connectées directement à deux parties mobiles et non directement à une partie fixe et à une partie mobile, les parties mobiles étant suspendues à une partie fixe, les moyens de suspension permettant de conduire le courant jusqu'aux poutres d'actionnement.

Les poutres d'actionnement peuvent être utilisées pour faire de l'auto test, par exemple pour des microphones, des accéléromètres, etc. Un microphone ou un accéléromètre ne nécessite pas de moyens d'actionnement pour son fonctionnement. Néanmoins on peut prévoir de tels moyens d'actionnement pour s'assurer de l'intégrité de la réponse mécanique de la structure mobile. En utilisant les jauges de détection comme moyen d'actionnement, il est possible de répondre à cette problématique sans ajouter des plots de connexion vers des électrodes d'actionnement et ainsi réduire les contraintes sur les dimensions du composant. Du fait du faible encombrement de poutres à actionnement électrothermiques leur intégration n'est pas ou peu problématique.

La mise en œuvre d'un actionnement électrothermique permet de réaliser une structure présentant un très faible encombrement. En outre de manière avantageuse, la structure peut présenter un rendement énergétique élevé, une telle structure est particulièrement adaptée à l'intégration dans des dispositifs portables et dans des capteurs que l'on cherche à miniaturiser.

Les poutres d'actionnement peuvent être utilisées pour compenser des efforts importants produits par des accélérations par exemple. L'asservissement par des moyens d'actionnement capacitif peut dans certain cas exiger des niveaux de tension très élevés difficilement disponibles pour des plateformes autonomes ou nomades. Grâce à la présente invention, du fait de l'intensité élevée de la force électrothermique qui peut être obtenue, un tel asservissement peut être envisagé.

La structure MEMS et/ou NEMS est réalisée par des techniques de la microélectronique et/ou de la nanoélectronique bien connues de l'homme du métier.

L'invention peut permettre de réaliser des gyromètres, les poutres servant à exciter la ou les parties mobiles du gyromètre et éventuellement à détecter leur déplacement.

L'invention peut être utilisée dans le domaine des capteurs et actionneurs résonants, par exemple pour réaliser des oscillateurs pour les bases de temps, la détection de masse biochimique, etc. et dans domaine des systèmes utilisant actionneurs requérant la génération de forces importantes afin de positionner ou déplacer un élément mécanique, tel qu'un interrupteur, un miroir, ou pour compenser des efforts extérieurs via une boucle de rétroaction, par exemple dans des accéléromètres, gyromètres asservis.

Sur la figure 13, on peut voir un autre exemple de réalisation d'une structure S10 représentée schématiquement permettant une adaptation de la force appliquée à la partie mobile de la structure et une amplification de l'amplitude de déplacement de la poutre d'actionnement.

La structure S10 met en œuvre un bras de levier 918 articulé autour d'un axe Z perpendiculaire au plan de la structure. Deux poutres d'actionnement 906 sont disposées d'un côté de l'axe de rotation et de part et d'autre du levier et la partie mobile 904 est disposée de l'autre côté du bras de levier et de l'autre côté de l'axe de rotation. Les deux poutres d'actionnement 906 sont pilotées par des sources de courant indépendantes. Les sources de courant peuvent être en opposition de phase. L'élément de liaison forme l'articulation en rotation du bras de levier 918.

En désignant par dl, la distance entre l'axe de rotation et le point d'application des forces électrothermique Fp sur le bras de levier et Dl la distance entre l'axe de rotation et le point d'application de la force Fm du bras de levier sur la partie mobile 904.

$$Fm = d1/D1 \times Fp.$$

Il est possible de réduire l'intensité de la force appliquée à la partie mobile.

Cette structure S10 permet d'avoir un déplacement appliqué à la partie mobile amplifié par rapport à celui de la poutre d'actionnement d'un rapport Dl/dl.

En variante, l'axe de rotation du bras de levier peut être parallèle au plan de la structure, par exemple en réalisant un axe de rotation déformable en torsion.

Sur la figure 14, l'articulation en rotation du bras de levier est formée par deux poutres R3 formant des éléments de liaison. La raideur des connexions entre le substrat et la partie mobile et entre le bras de leviers et la partie mobile sont représentées schématiquement par des ressorts R1 et R2 respectivement. Les ressorts R1 permettent le déplacement de la partie mobile 904 le long de l'axe Y et la raideur le long de l'axe T des ressorts R2 est élevée pour transmettre l'effort du bras de levier à la partie mobile. La raideur le long de l'axe Y des ressorts R2 est avantageusement au moins égale à deux fois la raideur le long de l'axe Y des ressorts R1. De plus, la raideur angulaire autour de l'axe Z des ressorts R2 est de l'ordre de grandeur de la raideur en rotation des poutres R3.

## Revendications

1. Structure microélectromécanique et/ou nanoélectromécanique à actionnement électrothermique comportant une partie fixe (502), au moins une partie mobile (504) par rapport à la partie fixe (502), au moins une première poutre d'actionnement (506.1) électrothermique permettant de faire circuler un courant électrique de la partie fixe à la partie mobile et au moins une deuxième poutre d'actionnement (506.2) électrothermique permettant de faire circuler un courant électrique de la partie fixe à la partie mobile, lesdites première et deuxième poutres d'actionnement étant reliées au moins mécaniquement à la partie mobile (504) et destinées à déplacer la partie mobile (504) par rapport à la partie fixe (502) par actionnement électrothermique, au moins un élément de liaison électriquement conducteur (508) reliant électriquement la partie mobile (504) à la partie fixe (502), des premiers moyens de connexion (P1) destinés à connecter la première poutre d'actionnement (506.1) à une première source de polarisation et des deuxièmes moyens de connexion (P2) destinés à connecter la deuxième poutre d'actionnement (506.2) à une deuxième source de polarisation, de sorte que la première (506.1) et la deuxième (506.2) puissent être polarisées différemment et séparément, **caractérisée en ce que** la première et/ou la deuxième poutre d'actionnement est un nanofil ou sont des nanofils.

2. Structure selon la revendication 1, dans laquelle les première et deuxième poutres d'actionnement (6) électrothermique comportent un ou plusieurs matériaux thermoélastiques aptes à se déformer sous l'effet d'un échauffement thermique induit par effet Joule par le courant électrique destiné à circuler dans lesdites poutres.

3. Structure selon la revendication 1 ou 2, dans laquelle la première et la deuxième poutre d'actionnement sont alignées et disposées de part et d'autre de la partie mobile.

4. Structure selon la revendication 1, 2 ou 3, dans laquelle l'élément de liaison (508) présente une forme telle qu'une force électrothermique générée en son sein ne s'oppose pas ou peu à la force électrothermique générée dans les poutres d'actionnement (506.1 et 506.2), l'élément de liaison (508) ayant avantageusement la forme d'un ressort en créneaux ou ladite structure comportant avantageusement deux éléments de liaison alignés le long d'un axe perpendiculaire à un axe auquel les première et deuxième poutres d'actionnement sont parallèles.

5. Structure selon l'une des revendications 1 à 4, dans laquelle l'épaisseur et/ou la largeur des nanofils est inférieure ou égale à 500 nm.

6. Structure selon l'une des revendications 1 à 5, comportant au moins un premier ensemble de plusieurs premières poutres d'actionnement (506.1) électrothermique aptes à appliquer simultanément une force électrothermique de même sens sur la partie mobile et \ou un deuxième ensemble de plusieurs deuxièmes poutres d'actionnement électrothermique (506.2), le premier ensemble et \ ou le deuxième ensemble étant connectés respectivement à la première et à la deuxième source de polarisation.

7. Structure selon l'une des revendications 1 à 6, comportant une articulation en rotation entre la partie fixe et la partie mobile et dans laquelle les première et deuxième poutres d'actionnement sont disposées par rapport à la partie mobile de sorte à provoquer sa rotation par rapport à la partie fixe, ladite rotation étant dans le plan de la structure ou hors-plan.

8. Structure selon les revendications 3 et 7, dans laquelle l'articulation en rotation comporte les deux éléments de liaison alignés définissant l'axe de rotation, lesdits éléments de liaison étant déformables en torsion et dans laquelle les première et deuxième poutres d'actionnement sont reliées mécaniquement à la partie mobile de sorte que les forces électrothermiques générées dans les poutres d'actionnement provoquent la rotation hors-plan de la partie mobile, l'articulation en rotation comportant avantageusement deux éléments de liaison dont les axes sont sécants.

9. Structure selon l'une des revendications 1 à 7, dans laquelle la partie mobile est reliée mécaniquement à la partie fixe par un ancrage, ledit ancrage formant un élément de liaison et dans laquelle les première et deuxième poutres d'actionnement sont orientées par rapport à la partie mobile pour provoquer sa déformation élastique.

10. Structure selon la revendication 7, dans laquelle l'articulation en rotation (808) est telle qu'elle permet également un déplacement en translation et dans laquelle les première et deuxième poutres d'actionnement sont reliées à un même côté de la partie mobile de part et d'autre de l'articulation, ladite structure comportant avantageusement deux premières poutres d'actionnement et deux deuxièmes poutres d'actionnement.

11. Structure selon l'une des revendications 1 à 10, dans laquelle les poutres d'actionnement (506.1, 506.2) présentent des épaisseurs (e3) inférieure ou égale à la moitié d'une épaisseur (e2) de la partie mobile (504) et inférieure ou égale à la moitié d'une épaisseur de l'élément de liaison (8) et/ou dans laquelle les poutres d'actionnement (506.1 et 506.2) présentent des rapports de forme compris entre 1 et 2.

12. Structure selon l'une des revendications 1 à 11, comportant des moyens de détection d'un déplacement de la partie mobile, lesdits moyens de détection étant par exemple des moyens piézorésistifs ou étant formés par au moins une des poutres d'actionnement.

13. Système comportant au moins une structure selon l'une des revendications 1 à 12, une première source de polarisation et une deuxième source de polarisation, par exemple les première et deuxième sources de polarisation étant de type continu et ayant des amplitudes différentes ou étant de type alternatif et étant en quadrature.

14. Système selon la revendication 13 formant capteur ou actionneur.

15. Procédé de commande d'un système selon la revendication 13, dans lequel les première et deuxième poutres d'actionnement sont polarisées avec des amplitudes différentes ou dans lequel les première et deuxième poutres d'actionnement sont polarisées en quadrature.

16. Procédé de commande d'un système selon la revendication 15, comportant des étapes :

   - échauffement de la partie mobile à une température donnée,
   - modulation d'une amplitude et/ou d'une phase des polarisations des première et deuxième sources de polarisation de sorte que le flux thermique sur la première poutre d'actionnement tend à augmenter la température donnée et le flux thermique de la deuxième poutre d'actionnement tend à diminuer la température donnée et de sorte que la température de la partie mobile soit sensiblement constante.

**Patentansprüche**

1. Mikroelektromechanische und/oder nanoelektromechanische Struktur mit elektrothermischer Betätigung, umfassend ein festes Teil (502), wenigstens ein bezüglich des festen Teils (502) bewegliches Teil (504), wenigstens einen ersten elektrothermischen Betätigungsbalken (506.1), der es erlaubt, einen elektrischen Strom von dem festen Teil zu dem beweglichen Teil zirkulieren zu lassen, und wenigstens einen zweiten elektrothermischen Betätigungsbalken (506.2), der es erlaubt, einen elektrischen Strom von dem festen Teil zu dem beweglichen Teil zirkulieren zu lassen, wobei der erste und der zweite Betätigungsbalken wenigstens mechanisch mit dem beweglichen Teil (504) verbunden und dazu ausgelegt sind, das bewegliche Teil (504) bezüglich des festen Teils (502) durch elektrothermische Betätigung zu verlagern, wenigstens ein elektrisch leitendes Verbindungselement (508), das das bewegliche Teil (504) elektrisch mit dem festen Teil (502) verbindet, erste Anschlussmittel (P1), die dazu ausgelegt sind, den ersten Betätigungsbalken (506.1) an eine erste Polarisationsquelle anzuschließen, und zweite Anschlussmittel (P2), die dazu ausgelegt sind, den zweiten Betätigungsbalken (506.2) an eine zweite Polarisationsquelle anzuschließen, derart, dass der erste (506.1) und der zweite (506.2) verschieden und voneinander unabhängig polarisiert werden können, **dadurch gekennzeichnet, dass** der erste und/oder der zweite Betätigungsbalken ein Nanodraht ist oder Nanodrähte sind.

2. Struktur nach Anspruch 1, wobei der erste und der zweite elektrothermische Betätigungsbalken (6) ein oder mehrere thermoelastische Materialien umfassen, die dazu ausgelegt sind, sich unter der Einwirkung einer thermischen Aufheizung zu verformen, die durch den Joule-Effekt mittels des elektrischen Stroms induziert wird, der dazu ausgelegt ist, in den Balken zu zirkulieren.

3. Struktur nach Anspruch 1 oder 2, wobei der erste und der zweite Betätigungsbalken ausgerichtet und auf beiden Seiten des beweglichen Teils angeordnet sind.

4. Struktur nach Anspruch 1, 2 oder 3, wobei das Verbindungselement (508) eine derartige Form aufweist, dass eine in seinem Inneren generierte elektrothermische Kraft nicht oder nur wenig der elektrothermischen Kraft entgegenwirkt, die in den Betätigungsbalken (506.1 und 506.2) generiert wird, wobei das Verbindungselement (508) vorzugsweise die Form einer Feder mit Schlitzen hat, oder die Struktur vorzugsweise zwei Verbindungselemente umfasst, die entlang einer Achse ausgerichtet sind, die orthogonal ist zu einer Achse, zu der der erste und der zweite Betätigungsbalken parallel sind.

5. Struktur nach einem der Ansprüche 1 bis 4, wobei die Dicke und/oder die Breite der Nanodrähte kleiner oder gleich 500 nm ist.

**6.** Struktur nach einem der Ansprüche 1 bis 5, umfassend wenigstens eine erste Gruppe von mehreren ersten elektrothermischen Betätigungsbalken (506.1), die dazu ausgelegt sind, gleichzeitig eine elektrothermische Kraft in der gleichen Richtung auf das bewegliche Teil auszuüben, und/oder eine zweite Gruppe von mehreren zweiten elektrothermischen Betätigungsbalken (506.2), wobei die erste Gruppe und/oder die zweite Gruppe an die erste beziehungsweise an die zweite Polarisationsquelle angeschlossen sind.

**7.** Struktur nach einem der Ansprüche 1 bis 6, umfassend ein Drehgelenk zwischen dem festen Teil und dem beweglichen Teil, und wobei der erste und der zweite Betätigungsbalken bezüglich des beweglichen Teils derart angeordnet sind, dass seine Drehung bezüglich des festen Teils bewirkt wird, wobei die Drehung in der Ebene der Struktur oder aus der Ebene heraus ist.

**8.** Struktur nach den Ansprüchen 3 und 7, wobei das Drehgelenk die zwei ausgerichteten Verbindungselemente umfasst, die die Drehachse definieren, wobei die Verbindungselemente torsionsverformbar sind, und wobei der erste und der zweite Betätigungsbalken mechanisch mit dem beweglichen Teil derart verbunden sind, dass die elektrothermischen Kräfte, die in den Betätigungsbalken generiert werden, die Drehung des beweglichen Teils aus der Ebene heraus bewirken, wobei das Drehgelenk vorzugsweise zwei Verbindungselemente umfasst, deren Achsen sich schneiden.

**9.** Struktur nach einem der Ansprüche 1 bis 7, wobei das bewegliche Teil mechanisch mit dem festen Teil durch eine Verankerung verbunden ist, wobei die Verankerung ein Verbindungselement bildet, und wobei der erste und der zweite Betätigungsbalken bezüglich des beweglichen Teils derart orientiert sind, dass seine elastische Verformung bewirkt wird.

**10.** Struktur nach Anspruch 7, wobei das Drehgelenk (808) derart ist, dass es ferner eine Translationsverlagerung erlaubt, und wobei der erste und der zweite Betätigungsbalken auf beiden Seiten des Gelenks mit ein und derselben Seite des beweglichen Teils verbunden sind, wobei die Struktur vorzugsweise zwei erste Betätigungsbalken und zwei zweite Betätigungsbalken umfasst.

**11.** Struktur nach einem der Ansprüche 1 bis 10, wobei die Betätigungsbalken (506.1, 506.2) Dicken (e3) kleiner oder gleich der Hälfte einer Dicke (e2) des beweglichen Teils (504) und kleiner oder gleich der Hälfte einer Dicke des Verbindungselements (8) aufweisen, und/oder wobei die Betätigungsbalken (506.1 und 506.2) Längenverhältnisse aufweisen, die zwischen 1 und 2 enthalten sind.

**12.** Struktur nach einem der Ansprüche 1 bis 11, umfassend Mittel zur Detektion einer Verlagerung des beweglichen Teils, wobei die Detektionsmittel beispielsweise piezoresistive Mittel sind, oder durch wenigstens einen der Betätigungsbalken gebildet sind.

**13.** System, umfassend wenigstens eine Struktur nach einem der Ansprüche 1 bis 12, eine erste Polarisationsquelle und eine zweite Polarisationsquelle, wobei beispielsweise die erste und die zweite Polarisationsquelle vom kontinuierlichen Typ sind, und verschiedene Amplituden haben, oder vom alternierenden Typ sind, und in Quadratur sind.

**14.** System nach Anspruch 13, das einen Sensor oder ein Betätigungselement bildet.

**15.** Verfahren zur Steuerung eines Systems nach Anspruch 13, wobei der erste und der zweite Betätigungsbalken mit verschiedenen Amplituden polarisiert werden, oder wobei der erste und der zweite Betätigungsbalken in Quadratur polarisiert werden.

**16.** Verfahren zur Steuerung eines Systems nach Anspruch 15, umfassend die folgenden Schritte:

- Heizen des beweglichen Teils auf eine gegebene Temperatur,
- Modulieren einer Amplitude und/oder einer Phase der Polarisationen der ersten und der zweiten Polarisationsquelle derart, dass der thermische Fluss auf dem ersten Betätigungsbalken dazu tendiert, die gegebene Temperatur zu erhöhen, und der thermische Fluss des zweiten Betätigungsbalkens dazu tendiert, die gegebene Temperatur zu verringern, und derart, dass die Temperatur des beweglichen Teils im Wesentlichen konstant ist.

**Claims**

**1.** Microelectromechanical and/or nanoelectromechanical structure with electrothermal actuation comprising a fixed part (502), at least one moveable part (504) with respect to the fixed part (502), at least one first electrothermal actuating beam (506.1) enabling an electric current to flow from the fixed part to the moveable part and at least one second electrothermal actuating beam (506.2) enabling an electric current to flow from the fixed part to the moveable part, said first and second actuating beams being connected at least mechanically to the moveable part (504) and configured to displace the moveable part (504) with respect to the fixed part (502) by electrothermal actuation, at least one electrically conductive connecting element (508) electrically connecting the moveable part (504) to the fixed part (502), a first circuitry for connecting (P1) the first actuating beam (506.1) to a first polarisation source and second circuitry for connecting (P2) the second actuating beam (506.2) to a second polarisation source, such that the first (506.1) and the second (506.2) can be polarised differently and separately, **characterized in that** the first and\or second actuating beam is a nanowire or are nanowires.

2. Structure according to claim 1, in which the first and second electrothermal actuating beams (6) comprise one or more thermoelastic materials capable of deforming under the effect of a thermal heating induced by Joule effect by the electric current intended to flow in said beams.

3. Structure according to claim 1 or 2, in which the first and the second actuating beams are aligned and arranged on either side of the moveable part.

4. Structure according to claim 1, 2 or 3, in which the connecting element (508) has a shape such that an electrothermal force generated within it does not oppose or opposes little the electrothermal force generated in the actuating beams (506.1 and 506.2), the connecting element (508) having advantageously a crenelated spring shape, or said structure comprising two connecting elements aligned along an axis perpendicular to an axis with which the first and second actuating beams are parallel.

5. Structure according to one of the claims 1 to 4, in which the thickness and/or the width of the nanowires is less than or equal to 500 nm.

6. Structure according to one of the claims 1 to 5, comprising at least one first set of several first electrothermal actuating beams (506.1) capable of applying simultaneously an electrothermal force of same direction on the moveable part and\or a second set of several second electrothermal actuating beams (506.2), the first set and\or the second set being connected respectively to the first and to the second polarisation source.

7. Structure according to one of the claims 1 to 6, comprising a rotational articulation between the fixed part and the moveable part and in which the first and second actuating beams are arranged with respect to the moveable part so as to cause its rotation with respect to the fixed part, said rotation being in the plane of the structure or out-of-plane.

8. Structure according to claims 3 and 7, in which the rotational articulation comprises the two aligned connecting elements defining the axis of rotation, said connecting elements being torsionally deformable and in which the first and second actuating beams are connected mechanically to the moveable part such that the electrothermal forces generated in the actuating beams cause the out-of-plane rotation of the moveable part, the rotational articulation advantageously comprising two connecting elements of which the axes are secant.

9. Structure according to one of the claims 1 to 7, in which the moveable part is mechanically connected to the fixed part by an anchoring, said anchoring forming a connecting element and in which the first and second actuating beams are oriented with respect to the moveable part to cause its elastic deformation.

10. Structure according to claim 7, in which the rotational articulation (808) is such that it also enables a translational displacement and in which the first and second actuating beams are connected to a same side of the moveable part on either side of the articulation, the structure advantageously comprising two first actuating beams and two second actuating beams

11. Structure according to one of the claims 1 to 10, in which the actuating beams (506.1, 506.2) have thicknesses (e3) less than or equal to half of a thickness (e2) of the moveable part (504) and less than or equal to half of a thickness of the connecting element (8) and/or in which the actuating beams (506.1 and 506.2) have aspect ratios comprised between 1 and 2.

12. Structure according to one of the claims 1 to 11, comprising a displacement detector for detecting a displacement of the moveable part, the displacement means for example being piezoresistive means or being formed by at least one of the actuating beams.

13. System comprising at least one structure according to one of the claims 1 to 12, a first polarisation source and a second polarisation source, for example the first and second polarisation sources are of direct type and having different amplitudes or are of alternating type and are in quadrature.

14. System according to claim 13 forming a sensor or an actuator.

15. Method for controlling a system according to claim 13, in which the first and second actuating beams are polarised with different amplitudes or in which the first and second actuating beams are polarised in quadrature.

16. Method for controlling a system according to claim 15, comprising the steps of:

- heating the moveable part to a given temperature,
- modulating an amplitude and/or a phase of the polarisations of the first and second polarisation sources such that the thermal flux on the first actuating beam tends to increase the given temperature and the thermal flux of the second actuating beam tends to reduce the given temperature and such that the temperature of the moveable part is substantially constant.

FIG.1

FIG.2A

FIG.2B

504

502    506.1'                                    506.2'    502    X

I0

FIG.3                                              508

S2

608.1                          604

ia                         F1                            F4                         ib

606.2                                                    606.2

608.2

FIG.4

FIG.5

FIG.6

FIG.7A

FIG.7B

EP 3 159 300 B1

FIG.8

FIG.9

**FIG.10**

**FIG.11**

1004.1

ib     1022     1022     ib     X

I1     $T + \Delta T$     $T - \Delta T$     I2     X

F

1006.1

-F

1006.2

1004.1

1004.2     1004

S9

FIG.12

d1

S10

906

918

906

c   Z

904

D1

FIG.13

FIG.14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6675578 B1

**Littérature non-brevet citée dans la description**

- **RAHAFROOZ A ; POURKAMALI S.** Thermal-Piezoresistive Energy Pumps in Micromechanical Resonant Structures. *IEEE Trans Electron Devices,* Décembre 2012, vol. 59 (12), 3587-93

- **XIABOBO GUO ; YUN-BO YI ; RAHAFROOZ A.** Pourkamali, Gas Sensing using thermally actuated dual plate resonators and self-sustained oscillators. *Frequency Control Symposium (FCS), 2012 IEEE International,* 2012, 1-5